(19) Europäisches Patentamt
European Patent Office
Office européen des brevets

(11) **EP 2 966 687 B1**

(12) **FASCICULE DE BREVET EUROPÉEN**

(45) Date de publication et mention
de la délivrance du brevet:
**28.09.2016 Bulletin 2016/39**

(51) Int Cl.:
***H01L 27/146*** *(2006.01)*   ***H04N 5/357*** *(2011.01)*

(21) Numéro de dépôt: **15170027.5**

(22) Date de dépôt: **01.06.2015**

(54) **CAPTEUR D'IMAGES CMOS**

CMOS-BILDERFASSUNGSSENSOR

CMOS IMAGE SENSOR

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **09.07.2014 FR 1456596**

(43) Date de publication de la demande:
**13.01.2016 Bulletin 2016/02**

(73) Titulaire: **COMMISSARIAT A L'ENERGIE
ATOMIQUE ET AUX
ENERGIES ALTERNATIVES
75015 Paris (FR)**

(72) Inventeurs:
• **Boukhayma, Assim**
  **CH-2000 Neuchâtel (FR)**
• **Peizerat, Arnaud**
  **38000 Grenoble (FR)**

(74) Mandataire: **Thibon, Laurent
Cabinet Beaumont
1, rue Champollion
38000 Grenoble (FR)**

(56) Documents cités:
**US-A1- 2006 202 242   US-A1- 2009 290 058
US-A1- 2011 267 505**

## Description

Domaine

La présente demande concerne le domaine des capteurs d'images CMOS. Elle vise notamment un capteur d'images CMOS à bruit réduit, adapté à fonctionner dans des conditions de faible luminosité.

Exposé de l'art antérieur

D'une manière classique, un capteur d'image CMOS comprend des pixels disposés en matrice selon des lignes et des colonnes. Chaque pixel comporte une photodiode utilisée en inverse, dont la capacité de jonction est déchargée par un photo-courant en fonction d'une intensité lumineuse reçue. A la fin d'une période dite d'acquisition d'image ou d'intégration, avant et après laquelle le pixel est réinitialisé par rechargement de sa photodiode, les charges photogénérées accumulées dans la photodiode sont transférées sur un noeud capacitif de lecture du pixel. La mesure du niveau d'éclairement reçu par le pixel s'effectue en mesurant la variation du potentiel du noeud de lecture du pixel, provoquée par le transfert, sur ce noeud, des charges photogénérées dans la photodiode du pixel.

En pratique, diverses sources de bruit sont susceptibles d'affecter la mesure, ce qui peut poser problème lorsque la quantité de charges photogénérées dans la photodiode est faible, notamment lorsque le capteur est utilisé dans des conditions de faible luminosité.

Il existe un besoin pour un capteur d'images CMOS palliant tout ou partie des inconvénients des capteurs existants. Plus particulièrement, il existe un besoin pour un capteur d'images CMOS à bruit réduit, adapté à fonctionner dans des conditions de faible luminosité.

Le document US2006/202242 décrit un capteur d'images à bruit réduit.

Résumé

Ainsi, un mode de réalisation prévoit un capteur d'images CMOS comportant au moins un pixel comportant : une photodiode dont une première borne est reliée à un premier potentiel de référence ; un premier transistor MOS reliant une seconde borne de la photodiode à un noeud de lecture du pixel ; un deuxième transistor MOS reliant le noeud de lecture à un deuxième potentiel de référence ; et un troisième transistor MOS monté en source suiveuse dont la grille est connectée au noeud de lecture et dont la source est destinée à être reliée à un circuit de lecture, dans lequel le troisième transistor présente une épaisseur d'oxyde de grille inférieure à l'épaisseur d'oxyde de grille des premier et deuxième transistors, la différence de potentiels entre les premier et deuxième potentiels de référence est supérieure à la tension maximale pouvant être appliquée entre deux bornes du troisième transistor MOS, et la région de corps ou la région de drain du troisième transistor est reliée à un troisième potentiel de référence compris entre les premier et deuxième potentiels.

Selon un mode de réalisation, la région de corps du troisième transistor est isolée de la région de corps du premier transistor et le potentiel appliqué sur la région de corps du troisième transistor est différent de celui appliqué sur la région de corps du premier transistor.

Selon un mode de réalisation, le troisième transistor est un transistor à canal P.

Selon un mode de réalisation, les premier et deuxième transistors sont des transistors à canal N, les régions de corps des premier et deuxième transistors sont reliées au premier potentiel de référence, la région de corps du troisième transistor est reliée au deuxième potentiel de référence, et la région de drain du troisième transistor est reliée au troisième potentiel de référence.

Selon un mode de réalisation, le pixel comporte en outre un quatrième transistor MOS reliant la source du troisième transistor à une piste de sortie du pixel.

Selon un mode de réalisation, le quatrième transistor présente une épaisseur d'oxyde de grille supérieure à l'épaisseur d'oxyde de grille du troisième transistor.

Selon un mode de réalisation, le quatrième transistor est un transistor du même type que celui du troisième transistor.

Selon un mode de réalisation, la photodiode est une diode pincée comprenant une région d'accumulation dopée de type N, formée dans un substrat dopé de type P, et une couche dopée de type P revêtant la région d'accumulation, cette couche présentant un niveau de dopage supérieur à celui du substrat.

Selon un mode de réalisation, les premier, deuxième et troisième transistors sont des transistors à canal N, les régions de corps des premier et deuxième transistors sont reliées au premier potentiel de référence, la région de corps du troisième transistor est reliée au troisième potentiel de référence, et la région de drain du troisième transistor est reliée à un quatrième potentiel de référence.

Selon un mode de réalisation, le troisième transistor présente une surface de grille inférieure à celle des premier et deuxième transistors.

## Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est un schéma électrique d'un exemple d'un pixel d'un capteur d'image CMOS ;
la figure 2 est une vue en coupe simplifiée du pixel de la figure 1 ;
la figure 3 est un schéma électrique d'un exemple d'un mode de réalisation d'un pixel d'un capteur d'image CMOS ; et
la figure 4 est une vue en coupe schématique illustrant un exemple de réalisation du pixel de la figure 3.

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

## Description détaillée

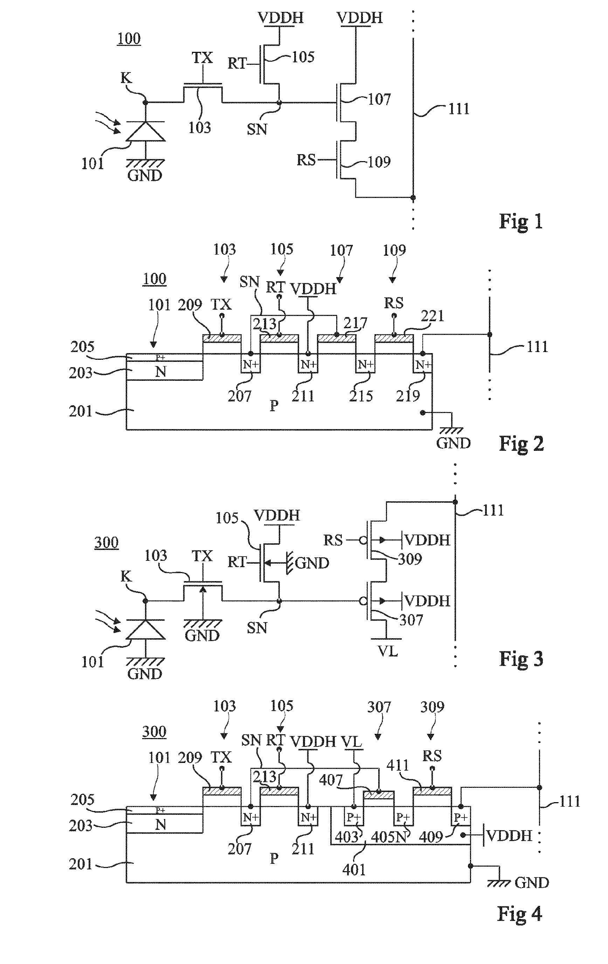

La figure 1 est un schéma électrique représentant un exemple d'un pixel 100 d'un capteur d'images CMOS. Le pixel 100 comprend une photodiode 101, un noeud d'accumulation K formé par la cathode de la photodiode 101, et un noeud de lecture SN. L'anode de la photodiode 101 est reliée à un noeud d'application d'un potentiel de référence bas GND, par exemple la masse. Le pixel 100 comprend en outre un transistor de transfert 103 dont les noeuds de conduction (source/drain) sont connectés respectivement au noeud K et au noeud SN, un transistor de réinitialisation 105 dont les noeuds de conduction sont connectés respectivement au noeud SN et à un noeud d'application d'un potentiel de référence haut VDDH, un transistor de lecture 107 monté en source suiveuse (connu sous la dénomination anglaise « source follower »), dont la grille est connectée au noeud SN et dont le drain est relié à un noeud d'application d'un potentiel de référence, et un transistor de sélection 109 dont les noeuds de conduction sont connectés respectivement à la source du transistor de lecture 107 et à une piste conductrice de sortie 111, généralement appelée colonne, qui peut être commune à plusieurs pixels du capteur.

Dans l'exemple représenté, les transistors 103, 105, 107 et 109 sont des transistors MOS à canal N, et le transistor 107, monté en source suiveuse (ou montage à drain commun), a son drain relié à un noeud d'application d'un potentiel de référence haut, le potentiel VDDH dans cet exemple.

En fonctionnement, les variations de potentiel du noeud SN sont reportées sur la source du transistor 107 sensiblement à l'identique, c'est-à-dire sans amplification ou avec un gain de l'ordre de 1. Le pixel 100 reçoit des signaux de commande TX, RT et RS appliqués respectivement sur les grilles des transistors 103, 105 et 109.

A titre d'exemple, le pixel 100 peut être commandé de la façon suivante :

- Pendant une phase d'intégration du pixel (précédée d'une étape de réinitialisation de la photodiode 101), le transistor de transfert 103 peut être maintenu non passant (signal TX à un état bas dans cet exemple) pour isoler le noeud d'accumulation K du noeud de lecture SN. Les charges électriques générées dans la photodiode 101 sous l'effet de la lumière entraînent alors une diminution progressive du potentiel du noeud K.
- Avant la fin de la phase d'intégration, le transistor de réinitialisation 105 peut être rendu passant (signal RST à un état haut dans cet exemple) de façon à réinitialiser le potentiel du noeud de lecture SN au potentiel VDDH, puis le transistor 105 peut être ouvert de façon à isoler le noeud SN du noeud VDDH.
- Après l'étape de réinitialisation du noeud SN, le potentiel du noeud SN peut être lu et mémorisé lors d'une première étape de lecture, de façon à constituer une référence pour une étape ultérieure de mesure du niveau de décharge de la photodiode. Pour cela, le transistor de sélection 109 est rendu passant (signal RS à un état haut dans cet exemple), de sorte que le potentiel du noeud SN est reporté sur la piste de sortie 111, par l'intermédiaire des transistors 107 et 109. Le potentiel de la piste 111 peut alors être lu et mémorisé, via un circuit de lecture non représenté.

- Après la première étape de lecture, le transistor de transfert 103 peut être fermé (signal TX à l'état haut dans cet exemple) de façon à provoquer le transfert des charges photogénérées accumulées dans la photodiode sur le noeud de lecture SN. Le potentiel du noeud SN diminue alors d'une valeur représentative de la quantité de charges photogénérées accumulée dans la photodiode, et donc de l'intensité lumineuse reçue par la photodiode, pendant l'intégration.
- Le potentiel du noeud SN, reporté sur la piste de sortie 111 par les transistors 107 et 109, peut alors être à nouveau lu lors d'une deuxième étape de lecture, par un circuit de lecture non représenté.

- La valeur de sortie du pixel est par exemple égale à la différence entre le potentiel de référence $V_{OUT1}$ lu sur la piste 111 lors de la première étape de lecture, et le potentiel $V_{OUT2}$ lu sur la piste 111 lors de la deuxième étape de lecture.

Un avantage de cette méthode de lecture, généralement désignée dans la technique par l'acronyme CDS, de l'anglais "Correlated Double Sampling" - échantillonnage double corrélé, est qu'il permet de s'affranchir au moins en partie de certaines sources de bruit, telles que le bruit de réinitialisation introduit par le transistor 105.

D'autres méthodes de lecture peuvent être utilisées pour réduire le bruit, par exemple une lecture du type généralement désigné dans la technique par l'acronyme CMS, de l'anglais "Correlated Multiple Sampling" - échantillonnage multiple corrélé, comprenant l'intégration de plusieurs échantillons successifs de la valeur de sortie du pixel, ce qui permet d'augmenter le rapport signal sur bruit.

La figure 2 est une vue en coupe simplifiée illustrant un exemple de réalisation du pixel 100 de la figure 1. Dans cet exemple, le pixel 100 est formé dans et sur une portion d'un substrat semiconducteur 201 (par exemple en silicium) dopé de type P.

La photodiode 101 est formée près de la surface du substrat 201, et comprend une région dopée de type N 203, surmontée d'une région dopée de type P 205 de niveau de dopage supérieur à celui du substrat 201. La région 203 définit une zone d'accumulation de charges photogénérées. Dans cet exemple, la photodiode 101 est une photodiode dite pincée (en anglais "pinned diode"), ou photodiode enterrée. En l'absence de charges photogénérées, le potentiel de la région d'accumulation 203 est défini par les niveaux de dopage des régions 201, 203 et 205, et est par exemple égal à 1,5 V. L'utilisation d'une diode pincée permet de réduire de façon significative le bruit du pixel, et plus particulièrement le bruit lié aux courants d'obscurité et le bruit de réinitialisation.

Le transistor 103 comprend une région 207 dopée de type N, par exemple de niveau de dopage supérieur à celui de la région 203, séparée de la photodiode 101 par une région du substrat 201, et une grille isolée 209 revêtant la surface du substrat 201 entre la photodiode 101 et la région 207. La région 207 définit le drain du transistor 103, et la région 203 définit la source du transistor 103. La portion du substrat 201 située sous la grille 209, entre les régions 203 et 207, définit une région de corps (aussi appelée "well" en anglais), ou région de formation de canal, du transistor 103.

Le transistor 105 comprend une région 211 dopée de type N, par exemple de même niveau de dopage que la région 207, séparée de la région 207 par une portion du substrat 201, et une grille isolée 213 revêtant la surface du substrat 201 entre la région 207 et la région 211. La région 207 définit la source du transistor 105, et la région 211 définit le drain du transistor 105. La portion du substrat 201 située sous la grille 213, entre les régions 207 et 211, définit la région de corps, ou région de formation de canal, du transistor 105.

Le transistor 107 comprend une région 215 dopée de type N, par exemple de même niveau de dopage que la région 207, séparée de la région 211 par une portion du substrat 201, et une grille isolée 217 revêtant la surface du substrat 201 entre la région 211 et la région 215. La région 215 définit la source du transistor 107, et la région 211 définit le drain du transistor 107. La portion du substrat 201 située sous la grille 217, entre les régions 211 et 215, définit la région de corps, ou région de formation de canal, du transistor 107.

Le transistor 109 comprend une région 219 dopée de type N, par exemple de même niveau de dopage que la région 207, séparée de la région 215 par une portion du substrat 201, et une grille isolée 221 revêtant la surface du substrat 201 entre la région 215 et la région 219. La région 219 définit la source du transistor 109, et la région 215 définit le drain du transistor 109. La portion du substrat 201 située sous la grille 221, entre les régions 215 et 219, définit la région de corps, ou région de formation de canal, du transistor 109.

Dans cet exemple, la grille 209 du transistor 103 est connectée à un noeud d'application du signal TX, la grille 213 du transistor 105 est connectée à un noeud d'application du signal RT, la grille 217 du transistor 107 est connectée au noeud SN, la grille 221 du transistor 109 est connectée à un noeud d'application du signal RS, la région 207 est reliée au noeud SN, la région 211 est reliée à un noeud d'application du potentiel de référence haut VDDH, le substrat 201 (et par conséquent l'anode de la diode 103 ainsi que les régions de corps des transistors 103, 105, 107 et 109) est relié à un noeud d'application du potentiel de référence bas GND, et la région 219 est reliée à la piste de sortie 111.

Une source de bruit particulièrement problématique dans les applications à faible niveau d'éclairement est le bruit de lecture produit par le transistor de lecture monté en source suiveuse, et plus particulièrement la composante en 1/f du bruit de lecture, aussi appelée bruit de scintillement. Cette source de bruit reste en effet significative même lorsqu'une lecture de type CDS ou CMS est mise en oeuvre, et peut devenir prépondérante dans des conditions de faible luminosité.

Sur la base de calculs analytiques détaillés dans un article intitulé "Comparison of two optimized readout chains for low light CIS", de Assim Boukhayma et al. (SPIE Proceedings Vol. 9022), dont le contenu est considéré comme faisant partie intégrante de la présente description, il a été montré que la variance $\overline{Q^2}$ (en [Coulomb$^2$]) du bruit de lecture en 1/f rapporté à l'entrée, introduit par le transistor de lecture monté en source suiveuse, peut s'exprimer comme suit :

$$\overline{Q^2} = \alpha_{CMS} \frac{K}{C_{ox}{}^2 WL} (C_{SN} + c_{GS}WL + c_{GD}W)^2,$$

K étant un paramètre proportionnel à kT dépendant de la technologie considérée (où k est la constante de Boltzman et T est la température absolue), $\alpha_{CMS}$ étant un facteur de réduction de bruit indépendant de la structure du pixel et dépendant uniquement du produit de la bande passante du circuit par le temps entre les échantillons lus, ainsi que du nombre d'échantillons accumulés (dans le cas d'une lecture de type CMS), $C_{OX}$ étant la capacité surfacique grille-substrat formée par l'oxyde de grille du transistor de lecture monté en source suiveuse, W et L étant respectivement la largeur et la longueur de grille du transistor de lecture, $C_{SN}$ étant la capacité du noeud de lecture SN, dépendant notamment des capacités parasites du transistor de réinitialisation et du transistor de transfert, et $c_{GS}$ et $c_{GD}$ étant respectivement la capacité surfacique grille-source et la capacité linéique grille-drain du transistor de lecture.

Généralement, dans une filière donnée de fabrication de puces de circuits intégrés en technologie CMOS, on dispose de deux épaisseurs d'oxyde de grille différentes pour réaliser des transistors MOS. De façon classique, dans un capteur d'images comportant des pixels à quatre transistors MOS du type décrit en relation avec les figures 1 et 2, les quatre transistors du pixel (les transistors 103, 105, 107 et 109) sont des transistors à oxyde épais. Les transistors à oxyde épais peuvent en effet fonctionner à des tensions nominales supérieures aux tensions nominales de fonctionnement des transistors à oxyde mince, et permettent ainsi de réaliser des pixels présentant une gamme dynamique (ou plage de mesure) plus importante. L'utilisation de transistors à oxyde épais est tout particulièrement adaptée lorsque la photodiode est une diode pincée du type décrit en relation avec la figure 2. Ce type de photodiode présente en effet une tension à vide (en l'absence de charges photogénérées) qui peut être relativement élevée, par exemple voisine de la tension nominale de fonctionnement des transistors MOS à oxyde mince. L'utilisation de transistors à oxyde mince ne permettrait alors pas d'obtenir une plage dynamique de fonctionnement du pixel suffisante.

Selon un aspect d'un mode de réalisation, on prévoit un pixel comportant une photodiode, un noeud de lecture, un transistor de transfert, un transistor de réinitialisation, et un transistor de lecture monté en source suiveuse, dans lequel le transistor de transfert et le transistor de réinitialisation sont des transistors à oxyde épais, et dans lequel le transistor de lecture est un transistor à oxyde mince. L'utilisation d'un transistor de lecture à oxyde mince permet d'augmenter la capacité surfacique grille-substrat formée par l'oxyde de grille du transistor de lecture par rapport à un pixel dans lequel le transistor de lecture est un transistor à oxyde épais. Les essais réalisés par les inventeurs ont montré que, dans un tel pixel, le bruit de lecture, et plus particulièrement le bruit en 1/f, est réduit de façon significative par rapport à un pixel dans lequel le transistor de lecture est un transistor à oxyde épais. De préférence, le transistor de lecture présente en outre une surface de grille (WL) inférieure à la surface de grille des transistors de transfert et de réinitialisation, et, plus généralement, inférieure à la surface de grille minimale des transistors à oxyde épais dans la technologie considérée. Ceci permet de réduire davantage la composante en 1/f du bruit de lecture.

Pour ne pas perdre en dynamique par rapport à un pixel dans lequel tous les transistors sont à oxyde épais, la région de corps du transistor de lecture est isolée des régions de corps des transistors de transfert et de réinitialisation. Les régions de corps et de drain du transistor de lecture sont polarisées de façon que le transistor de lecture puisse recevoir sur sa grille la totalité de l'excursion de potentiel du noeud de lecture SN (allant du potentiel de réinitialisation au potentiel de saturation du pixel), sans que la tension grille-drain ou grille-corps du transistor de lecture ne dépasse la tension nominale VDDL de fonctionnement d'un transistor MOS à oxyde mince. Les régions de corps et de drain du transistor de lecture sont par exemple polarisées de façon que la tension corps-drain du transistor de lecture soit égale à la tension nominale VDDL de fonctionnement des transistors MOS à oxyde mince. Les transistors de transfert et de réinitialisation restent, eux, polarisés à une tension de préférence égale à la tension nominale VDDH de fonctionnement des transistors MOS à oxyde épais pour maximiser la plage de valeurs de mesure possible.

La figure 3 est un schéma électrique d'un exemple de réalisation d'un pixel 300 d'un capteur d'image CMOS. Le pixel 300 comprend, comme le pixel 100 de l'exemple de la figure 1, une photodiode 101, un noeud d'accumulation K formé par la cathode de la photodiode 101, et un noeud de lecture SN. L'anode de la photodiode 101 est reliée à un noeud d'application d'un potentiel de référence bas GND, par exemple la masse. Le pixel 300 comprend en outre, comme dans l'exemple de la figure 1, un transistor de transfert 103 reliant le noeud K au noeud SN, et un transistor de réinitialisation 105 reliant le noeud SN à un noeud d'application d'un potentiel de référence haut VDDH. Le pixel 300 comprend en outre un transistor de lecture 307 monté en source suiveuse, dont la grille est connectée au noeud SN et dont le drain est relié à un noeud d'application d'un potentiel de référence intermédiaire VL, et un transistor de sélection 309 dont les noeuds de conduction sont connectés respectivement à la source du transistor de lecture 307 et à une piste conductrice de sortie 111, qui peut être commune à plusieurs pixels du capteur.

Dans l'exemple représenté, les transistors 103 et 105 sont des transistors MOS à canal N, et les transistors 307 et 309 sont des transistors MOS à canal P. Dans cet exemple, les transistors 103, 105 et 309 sont des transistors à oxyde épais, et le transistor 307 est un transistor à oxyde mince. Les transistors 103 et 105 ont leurs régions de corps reliées à un noeud d'application du potentiel de référence bas GND, et les transistors 307 et 309 ont leurs régions de corps reliées à un noeud d'application du potentiel de référence haut VDDH. Le transistor de lecture 307 a son drain relié à un noeud d'application d'un potentiel de référence intermédiaire VL, compris entre le potentiel de référence bas GND et le potentiel de référence haut VDDH. A titre de variante, la région de corps du transistor de lecture 307 peut être reliée à la source de ce même transistor.

En fonctionnement, les variations de potentiel du noeud SN sont reportées sur la source du transistor 307 sensiblement à l'identique. Le pixel 300 reçoit des signaux de commande TX, RT et RS appliqués respectivement sur les grilles des transistors 103, 105 et 309.

A titre d'exemple, le pixel 300 peut être commandé sensiblement de la même manière que le pixel 100 de la figure 1, en adaptant le niveau des signaux logiques en fonction du type de conductivité des transistors.

La tension VDDH (prise par rapport à la masse GND) correspond par exemple à la tension nominale d'alimentation des transistors MOS à oxyde épais dans la technologie considérée. Le potentiel intermédiaire VL appliqué sur le drain du transistor 307 peut être choisie de façon que, dans des conditions normales d'utilisation du pixel, le transistor 307 ne voie jamais une tension supérieure à la tension nominale VDDL (prise par rapport à la masse) de fonctionnement des transistors MOS à oxyde mince dans la technologie considérée. A titre d'exemple, la différence de tension VDDH-VL correspond à la tension nominale d'alimentation VDDL des transistors MOS à oxyde mince dans la technologie considérée.

A titre d'exemple illustratif non limitatif, on considère une filière technologique dans laquelle les transistors MOS à oxyde épais sont prévus pour fonctionner à des tensions pouvant aller jusqu'à 3,3 V, et les transistors MOS à oxyde mince sont prévus pour fonctionner à des tensions pouvant aller jusqu'à 1,8 V. Le potentiel de référence bas GND est par exemple égal à 0 V, et le potentiel de référence haut VDDH à 3,3 V. La photodiode 101 est par exemple une diode pincée présentant, en l'absence de charges photogénérées (après transfert des charges photogénérées sur le noeud de lecture SN), un potentiel de cathode égal à 1,5 V. Le potentiel de référence intermédiaire VL appliqué sur le drain du transistor de lecture 307 est par exemple égal à 1,5 V.

On notera qu'en pratique, l'oxyde épais est environ deux fois plus épais que l'oxyde mince, et la tension VDDH nominale d'alimentation des transistors MOS à oxyde épais est sensiblement inférieure ou égale à deux fois la tension nominale d'alimentation VDDL des transistors MOS à oxyde mince.

Si la tension à vide Vpin de la photodiode est du même ordre de grandeur que la tension nominale d'alimentation VDDL des transistors MOS à oxyde mince, alors la plage de variation du potentiel $V_{SN}$ (ou tension par rapport à la masse) au noeud de lecture a une amplitude sensiblement égale à VDDL. Plus précisément, le potentiel $V_{SN}$ varie entre une valeur Vpin et la tension maximale de réinitialisation du noeud SN, qui vaut VDDH-Vtn, où Vtn est la tension de seuil du transistor NMOS de réinitialisation. Si l'amplitude de variation au noeud SN, égale à VDDH-Vtn-Vpin, est inférieure à la tension VDDL alors il est possible de trouver un potentiel de référence VL du transistor de lecture qui permette de respecter la tension maximale pouvant être appliquée entre deux bornes du transistor de lecture. On notera que la présente invention est particulièrement intéressante dans le cas où les transistors 103, 105 avec un oxyde épais, sont sollicités avec des tensions entre leurs bornes particulièrement élevées (égale ou proche de la tension nominale VDDH) supérieures à la tension nominale VDDL pouvant être raisonnablement supportée par un transistor à oxyde mince. Dans ce cas de figure, l'utilisation d'une polarisation dédiée pour la région de corps du transistor de lecture ou l'utilisation d'une tension de polarisation adaptée du drain du transistor de lecture rend possible l'utilisation d'un transistor à oxyde mince pour le transistor de lecture. Autrement dit, l'utilisation d'un potentiel de référence intermédiaire VL différent des potentiels de référence bas GND et haut VDDH permet dans ce cas d'assurer un bon fonctionnement du transistor à oxyde mince.

Par ailleurs, le transistor de sélection 109 est de préférence un transistor MOS à oxyde épais. En effet, l'utilisation d'un transistor MOS à oxyde mince nécessiterait de commander sa grille avec une tension de commande présentant une excursion contrôlée pour ne pas endommager le transistor. Dans le cas de l'exemple décrit ci-dessus, en relation avec la figure 3, la tension de commande de la grille du transistor de sélection 109, en simple oxyde, pourrait par exemple osciller entre un niveau bas égal au potentiel de référence VL et le potentiel de référence haut VDDH. La tension de grille du transistor de sélection 109, de type PMOS dans cet exemple, étant nécessairement à une tension suffisamment élevée (VL) supérieure à GND (comme c'est le cas avec un transistor à oxyde épais), la résistance du transistor de sélection à l'état passant est plus élevée que dans le cas d'un transistor à oxyde épais. Ceci a pour conséquence de ralentir la lecture du pixel, ou de dégrader la valeur de tension transmise (si le temps de lecture du pixel ne permet pas une charge complète de la piste conductrice de sortie 111 (colonne). En outre la complexité du circuit est accrue dans le cas où les niveaux de commande de la grille du transistor de sélection doivent commuter entre des niveaux de potentiels ne correspondant pas à la masse ou une tension d'alimentation (VDDH, VDDL).

De plus, il est préférable que le transistor de sélection 309 soit du même type que celui du transistor de lecture 307, afin que le niveau de potentiel présent sur la source du transistor de lecture soit correctement transmis sur la piste conductrice de sortie 111 (colonne).

La figure 4 est une vue en coupe simplifiée illustrant un exemple de réalisation du pixel 300 de la figure 3. Dans cet exemple, le pixel 300 est formé dans et sur une portion d'un substrat semiconducteur 201 (par exemple en silicium) dopé de type P. La photodiode 101, le transistor 103 et le transistor 105 sont sensiblement identiques à ce qui a été décrit en relation avec la figure 2, et les transistors 307 et 309 sont réalisés dans un même caisson 401 dopé de type N, formé dans une partie supérieure du substrat 201.

Le transistor 307 comprend deux régions 403 et 405 dopées de type P, formées dans une partie supérieure du caisson 401 et séparées par une portion du caisson 401. Le transistor 307 comprend en outre une grille isolée 407 revêtant la surface du caisson 401 entre la région 403 et la région 405. La région 403 définit la région de drain du transistor 307, et la région 405 définit la région de source du transistor 307. La portion du caisson 401 située sous la grille 407, entre les régions 403 et 405, définit la région de corps, ou région de formation de canal, du transistor 307.

Le transistor 309 comprend une région 409 dopée de type P, par exemple de même niveau de dopage que les régions 403 et 405, séparée de la région 405 par une portion du caisson 401, et une grille isolée 411 revêtant la surface du caisson 401 entre la région 405 et la région 409. La région 405 définit la région de drain du transistor 309, et la région 409 définit la région de source du transistor 309. La portion du caisson 401 située sous la grille 411, entre les régions 405 et 409, définit la région de corps, ou région de formation de canal, du transistor 309.

Dans cet exemple, la grille 209 du transistor 103 est connectée à un noeud d'application du signal TX, la grille 213 du transistor 105 est connectée à un noeud d'application du signal RT, la grille 407 du transistor 307 est connectée au noeud SN, la grille 411 du transistor 309 est connectée à un noeud d'application du signal RS, la région 207 est reliée au noeud SN, la région 211 est reliée à un noeud d'application du potentiel de référence haut VDDH, le substrat 201 (et par conséquent l'anode de la diode 103 ainsi que les régions de corps des transistors 103 et 105) est relié à un noeud d'application du potentiel de référence bas GND, le caisson 401 (et par conséquent les régions de corps des transistors 307 et 309) est relié à un noeud d'application du potentiel de référence haut VDDH, la région 403 est reliée à un noeud d'application du potentiel de référence intermédiaire VL, et la région 409 est reliée à la piste de sortie 111.

Un avantage des modes de réalisation décrits en relation avec les figures 3 et 4 est qu'ils permettent, grâce à l'augmentation de capacité surfacique et, le cas échéant, à la diminution de surface de grille, du transistor de lecture, de réduire de façon significative le bruit de lecture du pixel par rapport à un pixel du type décrit en relation avec les figures 1 et 2. A titre d'exemple illustratif, avec une lecture de type CMS à 4 échantillons accumulés par lecture, les inventeurs ont mesuré un niveau de bruit en 1/f rapporté sur le noeud de lecture SN de 1,25 e- pour le pixel des figures 1 et 2, et de 0,2 e- seulement pour le pixel des figures 3 et 4.

Avantageusement, dans le cas d'un capteur d'images à plusieurs pixels, des pixels voisins peuvent partager un même caisson 401 de formation des transistors 307 et 309, ce qui permet de réduire l'encombrement du capteur.

Des modes de réalisation particuliers ont été décrits. Diverses variantes et modifications apparaîtront à l'homme de l'art.

En particulier, l'homme du métier saura adapter les modes de réalisation décrits au cas où le transistor de lecture monté en source suiveuse est un transistor MOS de type N. Dans ce cas, la région de corps du transistor de lecture est isolée des régions de corps des transistors de transfert et de réinitialisation à l'aide d'une structure à triple caisson, afin de pouvoir isoler la région de corps du transistor de lecture du substrat 201, afin de pouvoir les polariser à des tensions différentes. La région de corps du transistor de lecture est alors reliée à un noeud d'application d'un potentiel de référence intermédiaire VrefLow qui est de préférence inférieur ou égal à la tension minimale pouvant être présente sur la source du transistor, soit Vpin-Vt1 (où Vt1 est la tension de seuil du transistor de lecture à oxyde mince), par exemple 1,5V-0,5V = 1V. La région de drain du transistor de lecture est alors reliée à un noeud d'application d'un potentiel de référence haut VrefHigh par exemple égal à VrefLow + VDDL (VrefHigh est par exemple égal à 1V + 1,8V = 2,8V). Les potentiels de référence VrefLow et VrefHigh sont ainsi de préférence choisis de façon que le transistor de lecture ne voie jamais à ses bornes une tension supérieure à la tension nominale de fonctionnement des transistors à oxyde mince dans la technologie considérée.

Un tel mode de réalisation avec un transistor de lecture de type NMOS nécessite l'utilisation d'une structure à triple caisson qui est volumineuse et diminue la densité de pixels. En outre, deux références de tension VrefLow et Vrefhigh, différentes des tensions d'alimentation et de la masse, peuvent s'avérer nécessaire en pratique pour respecter les contraintes en tension du transistor à oxyde mince. Pour ce dernier point, il est éventuellement envisageable de polariser le drain du transistor de réinitialisation 105 à la même tension Vrefhigh que celle appliquée sur le drain du transistor de sélection NMOS car le niveau maximal pouvant passer à travers le transistor NMOS est égal à VDDH-Vtn2 (Vtn2 étant la tension de seuil du transistor NMOS de réinitialisation à oxyde épais), soit par exemple 3,3V-0,5V = 2,8V.

De plus, les inventeurs ont constaté en pratique que l'utilisation d'un transistor NMOS comme transistor de lecture ne permet pas d'avoir d'aussi bons résultats pour le bruit en 1/f qu'avec un transistor PMOS.

Ainsi, dans le cas d'une photodiode de type diode pincée associée à un transistor de transfert NMOS, le mode de réalisation préféré est celui décrit en relation avec la figure 3, avec des transistors de transfert et de réinitialisation de type NMOS à oxyde épais, un transistor de lecture de type PMOS à oxyde mince et un transistor de sélection de type PMOS à oxyde épais.

Bien que l'utilisation de photodiodes pincées de type opposé à celui représenté en figure 3 soit relativement rare, on pourrait avoir une photodiode N+/P/N, sur un substrat de type N, associée à un transistor de transfert de type PMOS. Dans ce cas, on pourrait envisager d'avoir uniquement des transistors de type PMOS, les transistors de transfert et de réinitialisation ayant un oxyde épais et le transistor de lecture ayant un oxyde mince, le transistor de sélection ayant de préférence un oxyde épais. En outre, dans le cas d'une telle photodiode N+/P/N, la cathode serait reliée au potentiel de référence haut VDDH et l'anode serait reliée au transistor de transfert.

En outre, bien que les exemples susmentionnés présentent des transistors de transfert et de réinitialisation du même type, ils pourraient être différents. Néanmoins, pour des raisons de densité et également de limitation des surfaces de caissons susceptibles de créer des diodes parasites, on préférera l'utilisation d'un même type de transistors.

Par ailleurs, les modes de réalisation décrits ne se limitent pas aux exemples numériques de potentiels de polarisation mentionnés ci-dessus.

De plus, les modes de réalisation décrits ne se limitent pas au cas particulier décrit ci-dessus, dans lequel la photodiode est une diode pincée.

En outre, le nombre de transistors présents dans le pixel n'est pas limité à 3 ou 4 comme cela apparaît dans les exemples décrits, le transistor de sélection pouvant être inutile dans certains cas. L'homme de l'art pourra rajouter d'autres transistors pour réaliser d'autres fonctions autres que celles décrites ci-dessus. On pourra notamment rajouter un transistor de réinitialisation globale, directement relié à la photodiode, pour réaliser des fonctions connues sous la dénomination anglaise « global shutter ».

## Revendications

1. Capteur d'images CMOS comportant au moins un pixel (300) comportant :

   une photodiode (101) dont une première borne est reliée à un premier potentiel de référence (GND) ;
   un premier transistor MOS (103) reliant une seconde borne de la photodiode (101) à un noeud de lecture du pixel (SN) ;
   un deuxième transistor MOS (105) reliant le noeud de lecture (SN) à un deuxième potentiel de référence (VDDH) ; et
   un troisième transistor MOS (307) monté en source suiveuse dont la grille (407) est connectée au noeud de lecture (SN) et dont la source est destinée à être reliée à un circuit de lecture ;

   le troisième transistor (307) présente une épaisseur d'oxyde de grille inférieure à l'épaisseur d'oxyde de grille des premier (103) et deuxième (105) transistors, **caractérisé en ce que** la différence de potentiels entre les premier (GND) et deuxième (VDDH) potentiels de référence est supérieure à la tension maximale pouvant être appliquée entre deux bornes du troisième transistor MOS (307), et **en ce que** la région de corps ou la région de drain du troisième transistor (307) est reliée à un troisième potentiel de référence (VL) compris entre les premier (VDDH) et deuxième (GND) potentiels.

2. Capteur selon la revendication 1, dans lequel la région de corps du troisième transistor (307) est isolée de la région de corps du premier transistor (103) et le potentiel (VL) appliqué sur la région de corps du troisième transistor (307) est différent de celui appliqué sur la région de corps du premier transistor (103).

3. Capteur selon la revendication 1 ou 2, dans lequel le troisième transistor (307) est un transistor à canal P.

4. Capteur selon la revendication 3, dans lequel les premier (103) et deuxième (105) transistors sont des transistors à canal N, les régions de corps des premier (103) et deuxième (105) transistors sont reliées au premier potentiel de référence (GND), la région de corps du troisième transistor (307) est reliée au deuxième potentiel de référence (VDDH), et la région de drain du troisième transistor (307) est reliée au troisième potentiel de référence (VL).

5. Capteur selon l'une quelconque des revendications 1 à 4, dans lequel ledit au moins un pixel (300) comporte en outre un quatrième transistor MOS (309) reliant la source du troisième transistor (307) à une piste de sortie (111) du pixel.

6. Capteur selon la revendication 5, dans lequel le quatrième transistor (309) présente une épaisseur d'oxyde de grille supérieure à l'épaisseur d'oxyde de grille du troisième transistor (309).

7. Capteur selon la revendication 5 ou 6, dans lequel le quatrième transistor (309) est un transistor du même type que celui du troisième transistor (307).

8. Capteur selon l'une quelconque des revendications 1 à 7, dans lequel la photodiode (101) est une diode pincée comprenant une région d'accumulation (203) dopée de type N, formée dans un substrat (201) dopé de type P, et une couche (205) dopée de type P revêtant la région d'accumulation (203), ladite couche (205) présentant un niveau de dopage supérieur à celui du substrat (201).

9. Capteur selon la revendication 2, dans lequel les premier (103), deuxième (105) et troisième transistors sont des transistors à canal N, les régions de corps des premier (103) et deuxième (105) transistors sont reliées au premier potentiel de référence (GND), la région de corps du troisième transistor (307) est reliée au troisième potentiel de référence (Vreflow), et la région de drain du troisième transistor (307) est reliée à un quatrième potentiel de référence (Vrefhigh).

10. Capteur selon l'une quelconque des revendications 1 à 9, dans lequel le troisième transistor (307) présente une surface de grille inférieure à celle des premier (103) et deuxième (105) transistors.


**Patentansprüche**

1. Ein CMOS Bildsensor, wobei der Bildsensor wenigstens ein Pixel (300) aufweist und wobei der Bildsensor Folgendes aufweist:

   eine Photodiode (101) mit einem ersten Anschluss, der mit einem ersten Referenzpotential (GND) verbunden ist;
   einen ersten MOS Transistor (103), der einen zweiten Anschluss der Photodiode (101) mit einem Abtastknoten (SN) des Pixel verbindet;
   einen zweiten MOS Transistor (105), der den Abtastknoten (SN) mit einem zweiten Referenzpotential (VDDH) verbindet; und
   einen dritten MOS Transistor (307), der hinzugefügt ist als ein Source-Nachfolger, wobei dessen Gate (407) vorgesehen ist, mit einem Leseschaltkreis verbunden zu sein;

   wobei der dritte Transistor (307) eine Gate Oxiddicke aufweist, die kleiner ist als die Gate Oxiddicke des ersten (103) und zweiten (105) Transistors, **dadurch gekennzeichnet, dass** die Potentialdifferenz zwischen dem ersten (GND) und dem zweiten (VDDH) Referenzpotential größer ist als die maximale Spannung, die zwischen die beiden Anschlüsse des dritten MOS Transistors (307) angelegt werden kann, und wobei der Kernbereich des Drain Bereichs des dritten Transistors (307) mit einem dritten Referenzpotential (VL) verbunden ist, wobei das dritte Referenzpotential im Bereich zwischen dem ersten (VDDH) und dem zweiten (GND) Potential liegt.

2. Der Sensor nach Anspruch 1, wobei der Kernbereich des dritten Transistors (307) von dem Kernbereich des ersten Transistors (103) isoliert ist und wobei das Potential (VL), das an den Kernbereich des dritten Transistors (307) angelegt wird, unterschiedlich zu dem ist, das an den Kernbereich des ersten Transistors (103) angelegt ist.

3. Der Sensor nach Anspruch 1 oder 2, wobei der dritte Transistor (307) ein P-Kanal Transistor ist.

4. Der Sensor nach Anspruch 3, wobei der erste (103) und der zweite (105) Transistor N-Kanal Transistoren sind, und wobei die Kernbereiche des ersten (103) und des zweiten (105) Transistors mit dem ersten Referenzpotential (GND) verbunden sind, wobei der Kernbereich des dritten Transistors (307) mit dem zweiten Referenzpotential (VDDH) verbunden ist, und wobei der Drain Bereich des dritten Transistors (307) mit dem dritten Referenzpotential (VL) verbunden ist.

5. Der Sensor nach einem der Ansprüche 1 bis 4, wobei das wenigstens eine Pixel (300) ferner einen vierten MOS Transistor (309) aufweist, der die Source des dritten Transistors (307) mit einem Ausgangsstrang (111) des Pixels verbindet.

6. Der Sensor nach Anspruch 5, wobei der vierte Transistor (309) eine Gate Oxiddicke aufweist, die größer ist als die Gate Oxiddicke des dritten Transistors (309).

7. Der Sensor nach Anspruch 5 oder 6, wobei der vierte Transistor (309) ein Transistor desselben Typs ist wie der dritte Transistor (307).

8. Der Sensor nach einem der Ansprüche 1 bis 7, wobei die Photodiode (101) eine gepinnte Diode ist, die einen N-Typ dotierten Speicherbereich (203) aufweist, der in einem P-Typ dotierten Substrat (201) ausgebildet ist, und wobei eine P-Typ dotierte Schicht (205) den Speicherbereich (203) bedeckt, wobei die Schicht (205) einen höheren Dotierungsgrad aufweist, als das Substrat (201).

9. Der Sensor nach Anspruch 2, wobei der erste (103), der zweite (105) und der dritte Transistor N-Kanal Transistoren sind, wobei die Kernbereiche des ersten (103) und des zweiten (105) Transistors mit dem ersten Referenzpotential (GND) verbunden sind, und wobei der Kernbereich des dritten Transistors (307) mit dem dritten Referenzpotential (Vreflow) verbunden ist, und wobei der Drain Bereich des dritten Transistors (307) mit einem vierten Referenzpotential (Vrefhigh) verbunden ist.

10. Der Sensor nach einen der Ansprüche 1 bis 9, wobei der dritte Transistor (307) einen Gate Oberflächenbereich aufweist, der kleiner ist als der des ersten (103) und des zweiten (105) Transistors.

**Claims**

1. A CMOS image sensor comprising at least one pixel (300) comprising:

   a photodiode (101) having a first terminal connected to a first reference potential (GND);
   a first MOS transistor (103) connecting a second terminal of the photodiode (101) to a sense node (SN) of the pixel;
   a second MOS transistor (105) connecting the sense node (SN) to a second reference potential (VDDH); and
   a third MOS transistor (307) assembled as a source follower having its gate (407) connected to the sense node (SN) and having its source intended to be connected to a read circuit;

   wherein the third transistor (307) has a gate oxide thickness smaller than the gate oxide thickness of the first (103) and second (105) transistors, **characterized in that** the potential difference between the first (GND) and second (VDDH) reference potentials is greater than the maximum voltage capable of being applied between two terminals of the third MOS transistor (307), and the body region or the drain region of the third transistor (307) is connected to a third reference potential (VL) in the range between the first (VDDH) and second (GND) potentials.

2. The sensor of claim 1, wherein the body region of the third transistor (307) is insulated from the body region of the first transistor (103) and the potential (VL) applied to the body region of the third transistor (307) is different from that applied to the body region of the first transistor (103).

3. The sensor of claim 1 or 2, wherein the third transistor (307) is a P-channel transistor.

4. The sensor of claim 3, wherein first (103) and second (105) transistors are N-channel transistors, the body regions of the first (103) and second (105) transistors are connected to the first reference potential (GND), the body region of the third transistor (307) is connected to the second reference potential (VDDH), and the drain region of the third transistor (307) is connected to the third reference potential (VL).

5. The sensor of any of claims 1 to 4, wherein said at least one pixel (300) further comprises a fourth MOS transistor (309) connecting the source of the third transistor (307) to an output track (111) of the pixel.

6. The sensor of claim 5, wherein the fourth transistor (309) has a gate oxide thickness greater than the gate oxide thickness of the third transistor (309).

7. The sensor of claim 5 or 6, wherein the fourth transistor (309) is a transistor of same type as the third transistor (307).

8. The sensor of any of claims 1 to 7, wherein the photodiode (101) is a pinned diode comprising an N-type doped storage region (203), formed in a P-type doped substrate (201), and a P-type doped layer (205) coating the storage region (203), said layer (205) having a higher doping level than the substrate (201).

9. The sensor of claim 2, wherein the first (103), second (105), and third transistors are N-channel transistors, the body regions of the first (103) and second (105) transistors are connected to the first reference potential (GND), the body region of the third transistor (307) is connected to the third reference potential (Vreflow), and the drain region of the third transistor (307) is connected to a fourth reference potential (Vrefhigh).

10. The sensor of any of claims 1 to 9, wherein the third transistor (307) has a gate surface area smaller than that of the first (103) and second (105) transistors.

Fig 1

Fig 2

Fig 3

Fig 4

**RÉFÉRENCES CITÉES DANS LA DESCRIPTION**

**Documents brevets cités dans la description**

- US 2006202242 A

**Littérature non-brevet citée dans la description**

- **ASSIM BOUKHAYMA et al.** Comparison of two optimized readout chains for low light CIS. *SPIE Proceedings,* vol. 9022